Europäisches Patentamt

European Patent Office

Office européen des brevets

(19)

(11) Numéro de publication: **0 309 333**
**A1**

## (12) DEMANDE DE BREVET EUROPEEN

(21) Numéro de dépôt: 88402366.4

(22) Date de dépôt: 20.09.88

(51) Int. Cl.⁴: **H 01 L 33/00**
H 01 L 31/18, H 01 L 21/20

(30) Priorité: 22.09.87 FR 8713057

(43) Date de publication de la demande:
29.03.89  Bulletin  89/13

(84) Etats contractants désignés: **DE GB NL**

(71) Demandeur: **THOMSON-CSF**
**173, Boulevard Haussmann**
**F-75379 Paris Cédex 08  (FR)**

(72) Inventeur: **Razeghi, Manijeh**
**Thomson-CSF SCPI 19, avenue de Messine**
**F-75008 Paris  (FR)**

Blondeau, Robert
*Thomson-CSF SCPI 19, avenue de Messine*
*F-75008 Paris  (FR)*

Omnes, Franck
*Thomson-CSF SCPI 19, avenue de Messine*
*F-75008 Paris  (FR)*

Defour, Martin
*Thomson-CSF SCPI 19, avenue de Messine*
*F-75008 Paris  (FR)*

Doriath, Gérard
*Thomson-CSF SCPI 19, avenue de Messine*
*F-75008 Paris  (FR)*

(74) Mandataire: **Grynwald, Albert et al**
**THOMSON-CSF SCPI 19, avenue de Messine**
**F-75008 Paris  (FR)**

(54) Dispositif optoélectronique à base de composés III-V sur substrat silicium.

(57) L'invention concerne un dispositif optoélectronique implanté sur substrat silicium (1) et comprenant notamment sur ce substrat un ensemble de couches d'adaptation (2) sur lequel est réalisé une première couche de confinement (3) à base de phosphure d'indium, une couche active (4) à base de $Ga_x In_{1-x} As_y P_{1-y}$
et une deuxième couche active (5) du phosphure d'indium.

Applications : Dispositif optoélectronique du domaine des télécommunications notamment.

FIG_1

SUBSTRAT

EP 0 309 333 A1

**Description**

## DISPOSITIF OPTOELECTRONIQUE A BASE DE COMPOSES III-V SUR SUBSTRAT SILICIUM

L'invention concerne un dispositif optoélectronique à base de composés III-V sur substrat silicium et notamment un dispositif à base de $Ga_x In_{1-x} As_y P_{1-y}/InP$ réalisé sur substrat silicium cristallin.

Les dispositifs optoélectroniques réalisés à base d'un composé quaternaire du type $Ga_x In_{1-x} As_y P_{1-y}$ à paramètre de maille adapté à celui du phosphure d'indium (InP) sont devenus très important dans l'industrie des matériels optoélectroniques en raison de leurs longueurs d'ondes et de leur photoluminescence importante.

De tels dispositifs ont été réalisés sur substrat à base de phosphure d'indium (InP). Cependant les substrats en phosphure d'indium présentent les inconvénients d'être très chers, de présenter des dislocations, d'être fragiles mécaniquement et d'avoir une conduction thermique médiocre.

Par ailleurs, ces dispositifs optoélectroniques posent des problèmes de dissipation thermique et il convient de les implanter sur des substrats assurant une bonne conduction thermique.

C'est pourquoi, selon l'invention on prévoit de réaliser de tels dispositifs sur un substrat en silicium cristallin en résolvant les problèmes de désadaptation en mailles qui existent entre les matériaux silicium et phosphore d'indium (InP). En effet, le silicium est maintenant peu coûteux et présente de bonnes caractéristiques thermiques et mécaniques.

Le dispositif optoélectronique de l'invention est applicable notamment dans les télécommunications à grandes distances.

L'invention concerne donc un dispositif optoélectronique, caractérisé en ce qu'il comporte au moins, empilés les uns sur les autres :
- un substrat en silicium cristallin, de paramètre de maille déterminé ;
- un ensemble de couches d'adaptation déposées successivement sur une face du substrat ;
- une première couche de confinement en matériau contenant au moins des éléments d'indium et de phosphore et ayant un deuxième paramètre de maille déterminé ;
- une couche active en matériau contenant au moins des éléments de gallium, d'indium, d'arsenic et de phosphore et de composition du type $Ga_x In_{1-x} As_{1-y} P_y$ avec y compris entre 0 et 1 ;
- une deuxième couche de confinement ;
l'ensemble de couches d'adaptation comportant, au moins une couche d'un matériau comportant notamment des éléments de gallium et d'arsenic et ayant un paramètre de maille qui diffère peu du premier paramètre de maille du substrat et, assurant une adaptation en maille de la première couche de confinement sur le substrat.

Les différents objets et caractéristiques de l'invention apparaîtront plus clairement dans la description qui va suivre faite à titre d'exemple en se reportant aux figures annexées qui représentent :
- La figure 1, un exemple de réalisation d'un dispositif optoélectronique selon l'invention ;
- la figure 2, un exemple de réalisation détaillé d'un réseau d'adaptation selon l'invention ;
- la figure 3, un autre exemple de réalisation d'un réseau d'adaptation selon l'invention comportant une couche tampon ;
- les figures 4 et 5, deux exemples de réalisation du réseau d'adaptation selon l'invention et comportant deux couches tampons.

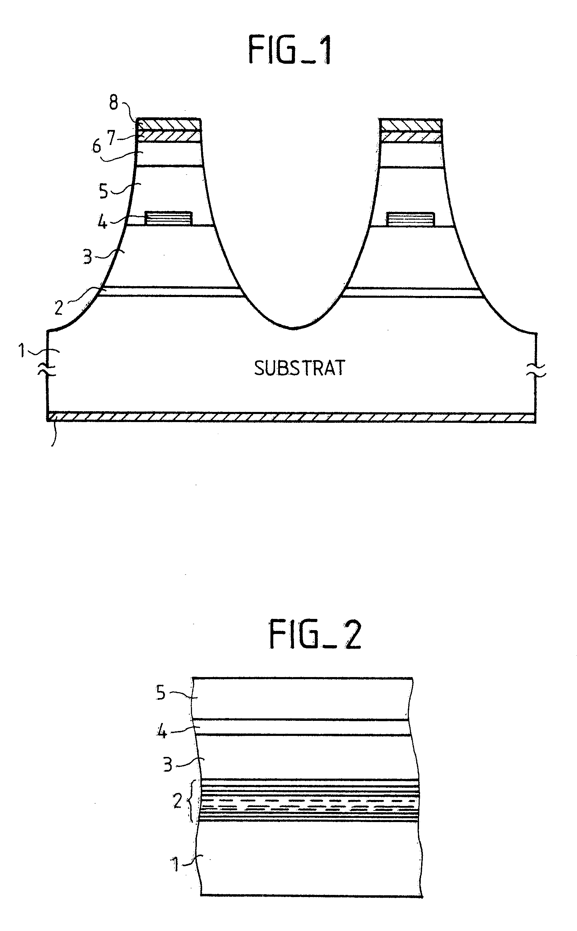

Sur la figure 1, on trouve deux dispositifs optoélectroniques selon l'invention réalisés en même temps sur le même substrat.

Le dispositif optoélectronique selon l'invention prévoit d'associer les qualités mécanique, électronique et thermique du silicium aux propriétés optoélectroniques ou hyperfréquences des composés des éléments III-V de la classification périodique des éléments.

Selon l'invention, le dispositif de l'invention tel que celui représenté en figure 1 est réalisé à base de
Ga In As P /InP
Le dispositif représenté permet de résoudre les problèmes de dislocations pouvant exister entre les composés III-V et le silicium.

C'est ainsi que, sur la figure 1, on trouve successivement, sur un substrat 1 en silicium cristallin :
- au moins une couche d'adaptation ou un ensemble de couches d'adaptation 2 qui peut être de façon simplifiée une couche d'arséniure de gallium (Ga As) ;
- une première couche de confinement 3 de phosphure d'indium (InP) dopé de type n ;
- une couche active 4 de composition générale :
$Ga_x In_{1-x} As_y P_{1-y}$
avec x compris entre 0 et 1
et y compris entre 0 et 1
- une deuxième couche de confinement 5 de phosphure d'indium (InP) dopée de type p ;
- une couche de contact 6 à base d'arséniure d'indium et de gallium (Ga In As) dopée de type p ;
- une couche de contact électrique 7 en platine par exemple ;
- une couche métallique 8, en or par exemple permettant un bon contact électrique avec des circuits extérieurs, une autre couche métallique 9 de même nature déposée directement sur le substrat fournissant au dispositif optoélectronique, un autre contact électrique.

Le dispositif de l'invention réalisé avec, en lieu et place de l'ensemble de couches d'adaptation 2, une couche d'arséniure de gallium (Ga As), a permis de mettre en évidence que les dislocations entre un substrat silicium et un composant réalisé à partir de composés III-V de la classification périodique des éléments (tel que Ga In As P/InP) étaient atténuées de façon significative.

Cependant, selon l'invention on prévoit également de réaliser l'ensemble de couches d'adaptation 2 de façon plus complète de façon à obtenir une meilleure adaptation du composant optoélectronique sur le substrat silicium et à coucher les lignes de dislocations pouvant exister.

La figure 2 représente un composant optoélectronique similaire à celui de la figure 1 dans lequel l'ensemble de couches d'adaptation 2 est réalisé sous forme d'un super-réseau constitué, par exemple, d'une succession alternée de couches d'arséniure de gallium (Ga As) et de phosphure d'indium et de gallium (Ga InP). Chaque couche à une épaisseur comprise entre 10 et 50 angstroems. Le nombre de couches est alors compris entre 10 et 100.

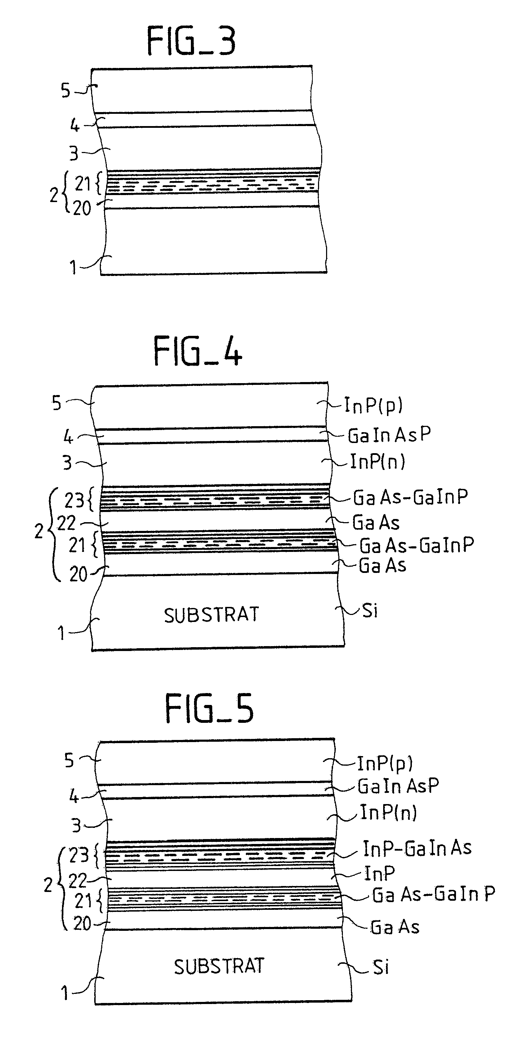

La figure 3 représente un dispositif optoélectronique selon l'invention comportant, sur le substrat 1 en silicium cristallin, une couche tampon 20 en matériau de paramètre de maille qui diffère peu du paramètre de maille du silicium cristallin. Par exemple, la couche tampon 20 sera réalisée en arséniure de gallium (Ga As). Sur la couche tampon 20 est réalisé un super-réseau d'adaptation 21 de couches alternées d'arséniure de gallium (Ga As) et de phosphure d'indium et de gallium (Ga InP). La couche tampon 20 et le super-réseau 21 constituent l'ensemble de couches d'adaptation 2 sur lequel se trouvent la première couche de confinement 3, la couche active 4 et la deuxième couche de confinement 5.

A titre d'exemple, la couche tampon 20 a une épaisseur de 10 à 500 angstroems, les couches du super-réseau 21 ont chacune une épaisseur de10 à 50 angstroems . Le nombre de couches du super-réseau 21 est supérieur à 10 et de façon pratique compris entre 10 et 50.

La figure 4 représente un exemple de réalisation perfectionnée du dispositif de l'invention. Il comporte sur le substrat 1, une première couche tampon 20, un premier super-réseau d'adaptation 21, une deuxième couche tampon 22 un deuxième super-réseau d'adaptation 23 et le composant optoélectronique lui-même constitué des couches de confinement 3, 5 et de la couche active 4. Les couches tampon 20, 22 et les super-réseaux d'adaptation 21, 23 constituent l'ensemble de couches d'adaptation 2.

Comme précédemment, les couches tampon 20, 22 et les super-réseaux d'adaptation 21, 23 sont en matériaux permettant une adaptation entre la couche de confinement 3 et la couche 1 de silicium.

A titre d'exemple, le composant optoélectronique de la figure 4 est constitué de la manière suivante :
- substrat 1 en matériau silicium cristallin ;
- couche tampon 20 en matériau à base d'arséniure de gallium (Ga As), d'épaisseur supérieur à 10 angstroems et de préférence comprise entre 10 et 500 angstroems ;
- super-réseau d'adaptation 21 constitué, de façon alternée, de couches à base d'arséniure de gallium (Ga As) et de couches à base de phosphure d'indium et de gallium (GaInP), l'épaisseur de chaque couche étant supérieure à 10 angstroems et de préférence comprise entre 10 et 50 angstroems. Dans les couches de GaInP la composition relative de gallium et d'indium sera de 50 % - 50% ($Ga_{0,5}$ $In_{0,5}$ P). De plus le nombre de couches sera supérieur à cinq et le dispositif donnera un bon résultat avec un nombre de couches de 10. Enfin, la couche de ce super-réseau la plus proche de la couche tampon 20 sera à base d'arséniure de gallium tandis que la couche la plus proche de la couche tampon 22 sera à base de phosphure d'indium et de gallium ;
- couche tampon 22 en matériau à base d'arséniure de gallium (Ga As) d'épaisseur supérieur à 10 angstroems et de préférence comprise entre 10 et 500 angstroems ;
- super-réseau d'adaptation 23 réalisé de façon similaire au super-réseau d'adaptation 21 ;
- couche de confinement 3 à base de phosphure d'indium dopé n d'environ 2 micromètres d'épaisseur ;
- couche active 4 de composition de base $Ga_x$ $In_{1-x}$ $As_y$ $P_{1-y}$ avec x et y compris chacun entre 0 et 1 et d'épaisseur d'environ 2000 angstroems ;
- couche de confinement à base de phosphure d'indium dopé p, d'épaisseur d'environ 500 angstroems.

La figure 5 représente un autre exemple de réalisation comprenant sur le substrat 1 une première couche tampon 20, un premier super-réseau 21 une deuxième couche tampon 22 et un deuxième super-réseau 23. Cet exemple de réalisation diffère de celui de la figure 4 par la constitution de la deuxième couche tampon 22 et du deuxième super-réseau 23.

La deuxième couche tampon 22 est en matériau analogue à celui de la première couche de confinement 3 et est par exemple à base de phosphure d'indium (InP) Son épaisseur est supérieur à 10 angstroems et est par exemple compris entre 10 et 500 angstroems.

Le super-réseau 23 est constitué, de façon alternée, de couches à base de phosphure d'indium (InP) et de couches à base d'arséniure de gallium et d'indium. Dans les couches de Ga In AS les proportions de gallium et d'indium seront par exemple de 47 % de gallium et 53 % d'indium ($Ga_{0,47}$ $In_{0,53}$ As). L'épaisseur de chaque couche du super-réseau 23 est supérieur à 10 angstroems et leur nombre est par exemple de 10.

La réalisation des différents dispositifs ainsi décrit se fera par un procédé connu d'épitaxie tel que par épitaxie en phase vapeur d'organométalliques MOCVD (Metalorganic Chemical Vapor Deposition) ou par épitaxie par jets molécules (Molecular Beam Electronic) ou par toute combinaison de ces deux procédés.

L'invention permet ainsi d'obtenir sur un substrat silicium un laser enterré BH (Buried Heterostructure) à double hétérostructure fonctionnant à une longueur d'onde de 1,15 μm.

Un tel laser ainsi réalisé a permis une observation de l'électroluminescence en infrarouge en régime continu sous pointe à 200 mA. Un fonctionnement pendant 24 heures en continu à 120 mA sans perte de l'intensité lumineuse a également été observé.

Il est bien évident que la description qui précède n'a été faite qu'à titre d'exemple non limitatif. D'autres variantes peuvent être envisagées sans sortir du cadre de l'invention. Les exemples numérique notamment et les exemples de matériaux utilisés n'ont été fournis que pour illustrer la description.

## Revendications

1. Dispositif optoélectronique, caractérisé en ce qu'il comporte au moins, empilés les uns sur les autres :
- un substrat (1) en silicium cristallin, de paramètre de maille (m1) déterminé ;
- un ensemble de couches d'adaptation (2) déposées successivement sur une face du substrat ;
- une première couche de confinement (3) en matériau contenant au moins des éléments d'indium et de phosphore et ayant un deuxième paramètre de maille déterminé ;
- une couche active (4) en matériau contenant au moins des éléments de gallium, d'indium, d'arsenic et de phosphore et de composition du type
$Ga_x In_{1-x} As_{1-y} P_y$
avec y compris entre 0 et 1 ;
- une deuxième couche de confinement (5) ;
l'ensemble de couches d'adaptation (2) comportant au moins une couche d'un matériau comportant notamment des éléments de gallium et d'arsenic et ayant un paramètre de maille qui diffère peu du premier paramètre de maille (m1) du substrat (1) et, assurant une adaptation en mailles de la première couche de confinement (3) sur le substrat (1).

2. Dispositif optoélectronique selon la revendication 1, caractérisé en ce que l'ensemble de couches d'adaptation (2) comporte d'une part, du côté du substrat 1, au moins une couche d'un matériau comportant, notamment des éléments de gallium et d'arsenic, et ayant un paramètre de mailles qui diffère peu du premier paramètre de maille (m1) du substrat (1) et d'autre part, du coté de la première couche de confinement (3), au moins une couche d'un matériau de nature analogue à celle de la première couche de confinement (3) et ayant un paramètre de maille adapté à celui de la première couche de confinement (3).

3. Dispositif selon la revendication 1, caractérisé en ce que l'ensemble de couches d'adaptation (2) est un réseau d'adaptation comportant, de façon alternée, des couches contenant des éléments d'arsenic et de gallium et des couches contenant des éléments d'indium et de phosphore.

4. Dispositif selon la revendication 1, caractérisé en ce que l'ensemble de couches d'adaptation (2) comporte au moins une première couche tampon (20) en matériau à base d'arsenic et de gallium située sur le substrat (1) et au moins un premier super-réseau d'adaptation (21) situé sur la couche tampon (20) et comportant de façon alternée des couches contenant des éléments d'arsenic et de gallium et des couches contenant des éléments d'indium et de phosphore.

5. Dispositif selon la revendication 4, caractérisé en ce que l'ensemble des couches d'adaptation comporte empilés sur le premier réseau d'adaptation (21), une deuxième couche tampon (22) et un deuxième super-réseau d'adaptation (23).

6. Dispositif selon la revendication 5, caractérisé en ce que la deuxième couche tampon (22) est en matériau à base de gallium et d'arsenic.

7. Dispositif selon la revendication 5, caractérisé en ce que la deuxième couche tampon (22) est en matériau à base d'indium et de phosphore.

8. Dispositif selon la revendication 6, caractérisé en ce que
- le premier super-réseau d'adaptation (21) comporte, de façon alternée, des couches de matériau à base d'arsenic et de gallium et des couches de matériau à base de gallium, d'indium et de phosphore ;
- le deuxième super-réseau d'adaptation (23) comporte, de façon alternée, des couches de matériau à base d'arsenic et de gallium et des couches de matériau à base de gallium, d'indium et de phosphore.

9. Dispositif selon la revendication 7, caractérisé en ce que
- le premier super-réseau d'adaptation (21) comporte, de façon alternée, des couches de matériau à base de gallium et d'arsenic et des couches de matériau à base de gallium, d'indium et de phosphore ;
- le deuxième super-réseau d'adaptation (23) comporte de façon alternée, des couches de matériau à base d'indium et de phosphore et des couches à base de gallium, d'indium et d'arsenic.

10. Dispositif selon la revendication 1, caractérisé en ce que l'ensemble de couches d'adaptation (2) comporte des couches alternées, d'épaisseur comprise entre 10 et 50 angstroems, d'une part d'un matériau à base d'arsenic et de gallium et d'autre part d'un matériau dont le paramètre de maille est sensiblement adapté à celui de la première couche de confinement, le nombre de couches de l'ensemble de couches d'adaptation étant compris entre 10 et 100.

11. Dispositif selon la revendication 4, caractérisé en ce que :
- l'épaisseur de la première couche tampon (20) est supérieure à 10 angstroems ;
- le premier super-réseau d'adaptation (21) comporte au moins 5 couches d'épaisseur supérieure chacune à 10 angstroems.

12. Dispositif selon la revendication 5, caractérisé en ce que :
- l'épaisseur de la deuxième couche tampon (22) est supérieur à 10 angstroems ;
- le deuxième super-réseau d'adaptation (23) comporte au moins 5 couches d'épaisseur supérieure chacune à 10 angstroems.

# FIG_1

8
7
6
5
4
3
2
1

SUBSTRAT

# FIG_2

5
4
3
2
1

## FIG_3

## FIG_4

5 — InP(p)
4 — Ga In As P
3 — InP(n)
23 — Ga As–GaInP
22 — Ga As
21 — Ga As–GaInP
20 — Ga As
SUBSTRAT — Si

## FIG_5

5 — InP(p)
4 — Ga In As P
3 — InP(n)
23 — InP–Ga In As
22 — InP
21 — Ga As–Ga In P
20 — Ga As
SUBSTRAT — Si

---

Office européen
des brevets

# RAPPORT DE RECHERCHE EUROPEENNE

Numero de la demande

EP  88 40 2366

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | EP-A-0 177 903 (DAIDOTOKUSHUKO K.K.) * En entier * --- | 1-4,11 | H 01 L  33/00 |
| A | US-A-4 561 916 (M. AKIYAMA et al.) * En entier * --- | 1,2 | H 01 L  31/18 <br> H 01 L  21/20 |
| A | IBM TECHNICAL DISCLOSURE BULLETIN, vol. 22, no. 1, juin 1979, page 401, New York, US; R. HUNG et al.: "Integrated light-emitting devices with silicon LSI circuits" * En entier * --- | 1 | |
| A | PATENT ABSTRACTS OF JAPAN, vol. 9, no. 266 (E-352)[1989], 23 octobre 1985, page 129 E 352; & JP-A-60 113 488 (NIPPON DENKI K.K.) 19-06-1985 --- | | |
| A | ELECTRONICS LETTERS, vol. 20, no. 22, 25 octobre 1984, pages 916-918, Hitchin., Herts., GB; T. SOGA et al.: "MOCVD growth of GaAs on Si substrates with AlGaP and strained superlattice layers" * En entier * --- | 1 | |
| A | US-A-4 468 850 (ZONG-LONG LIAU et al.) ----- | | |

DOMAINES TECHNIQUES RECHERCHES (Int. Cl.4)

H 01 L

Le présent rapport a été établi pour toutes les revendications

| Lieu de la recherche | Date d'achèvement de la recherche | Examinateur |
|---|---|---|
| LA HAYE | 16-11-1988 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................................
& : membre de la même famille, document correspondant

EPO FORM 1503 03.82 (P0402)